# EUROPEAN PATENT SPECIFICATION

(11) **EP 2 048 697 B1**
(45) Date of publication and mention of the grant of the patent: **14.10.2015**
(21) Application number: 07744943.7
(22) Date of filing: 08.06.2007
(51) Int. Cl.: H01L 21/322, H01L 27/12, H01L 21/762

(54) **METHOD FOR REUSING DELAMINATED WAFER**
VERFAHREN ZUR WIEDERVERWENDUNG EINES ENTFERNTEN WAFERS
PROCÉDÉ DE RÉUTILISATION DE TRANCHE DÉLAMINÉE

(30) Priority: 14.07.2006 JP 2006193606
(43) Date of publication of application: 15.04.2009
(73) Proprietor: Shin-Etsu Handotai Co., Ltd., Tokyo (JP)
(72) Inventor: TAMURA, Akihiko, Chiyoda-ku, Tokyo 100-0004 (JP); OKI, Konomu, Chiyoda-ku, Tokyo 100-0004 (JP)
(74) Representative: Wibbelmann, Jobst
(86) International application number: PCT/JP2007/061623
(87) International publication number: WO 2008/007508

(56) References cited:
- EP-A1- 0 955 671
- EP-A1- 1 835 533
- WO-A1-01/28000
- FR-A1- 2 881 573
- JP-A- 11 307 413
- JP-A- 11 307 413
- JP-A- 11 316 154

## Description

### TECHNICAL FIELD

The present invention relates to a method for reusing a delaminated wafer byproduced in a so-called ion implantation delamination method (which is also called a smart cut (a registered trademark) method) for delaminating an ion-implanted wafer after bonding to manufacture an SOI (Silicon On Insulator) wafer.

### BACKGROUND ART

Although there are several methods for manufacturing an SOI wafer, a method for manufacturing an SOI wafer that uses a bonding method is characterized in that two silicon single crystal wafers are bonded through an oxide film. However, its cost is very high since one SOI wafer is manufactured from two wafers.

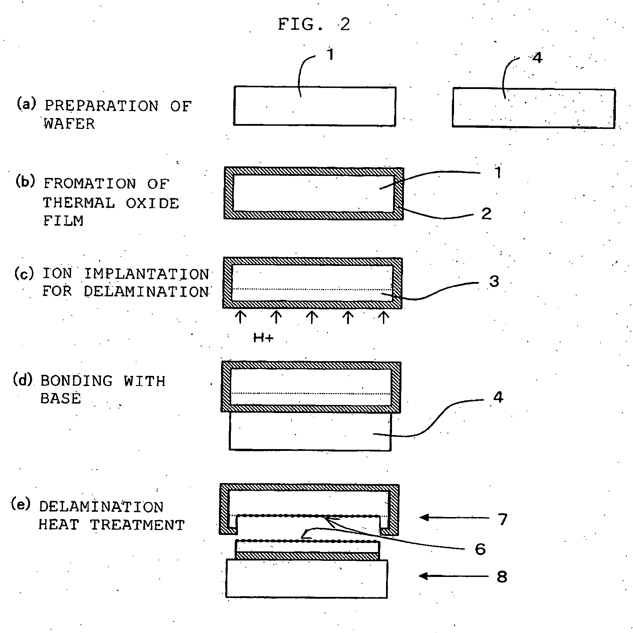

Improving this method results in a method for manufacturing an SOI wafer based on an ion implantation delamination method. FIG. 2 shows a flow of a manufacturing process for an SOI wafer based on the ion implantation delamination method. The ion implantation delamination method will now be explained hereinafter with reference to FIG. 2.

This is a technology for manufacturing an SOI wafer 8 by preparing two silicon wafers, i.e., a bond wafer 1 and a base wafer 4 (a step (a)), forming an oxide film 2 on at least one silicon wafer (the bond wafer 1 in this example) (a step (b)), then implanting a hydrogen ion or a rare gas ion from an upper surface of the one silicon wafer to form a micro bubble layer (an ion implanted layer 3) in the wafer (a step (c)), bringing the ion-implanted surface into close contact with the other silicon wafer (the base wafer 4 in this example) through the oxide film 2 (a step (d)), thereafter applying a heat treatment to delaminate the one wafer in the form of a thin film at the ion-implanted layer being used as a cleavage plane 6 (a step (e)), and further applying a heat treatment to firmly bond (not shown) (see Japanese Patent Application Laid-open No. 5-211128).

According to this method, the cleavage plane (a delaminating plane) 6 is a good mirror-like surface, and the SOI wafer having high uniformity of a film thickness of an SOI layer can be relatively easily obtained.

When the SOI wafer 8 is fabricated according to such an ion implantation delamination method, one silicon.delaminated wafer 7 is necessarily by produced. Since reusing this byproduced delaminated wafer enables substantially obtaining one SOI wafer from one silicon wafer, a cost can be greatly reduced.

In this case, since the byproduced delaminated wafer 7 cannot be reused as it is, the delaminating plane 6 must be subjected to regeneration processing.

Thus, Japanese Patent Application Laid-open No. 11-307413 discloses a method for reusing a delaminated wafer by carrying out reprocessing, e.g., polishing with respect to a delaminating plane of each delaminated wafer byproduced when using an epitaxial wafer as a bond wafer, a silicon wafer fabricated based on a Czochralski method (a CZ method) (which will be referred to as a CZ wafer hereinafter), and a silicon wafer fabricated based on a floating zone method (an FZ method) (which will be referred to as an FZ wafer hereinafter).

In particular, as the reprocessing for a delaminated wafer, there is adopted a method for improving a damaged layer formed in a delaminated wafer and surface roughness of a delaminating plane by applying a heat treatment to the delaminated wafer in a reducing atmosphere containing hydrogen without performing finish polishing requiring a large stock removal after polishing for removing a peripheral step in order to reduce the stock removal of polishing and completely remedy surface roughness.

However, manufacture of the large-diameter FZ wafer having a diameter of 200 mm or above is difficult, and it is hard to be applied to future advanced devices. Further, when the epitaxial wafer is used, even if a stock removal is reduced as much as possible in a regeneration process, the number of times of regeneration is reduced to be smaller than that in a case using a regular CZ wafer or FZ wafer since an epitaxial layer is thin from the beginning, thereby substantially resulting in a considerable increase in cost. Furthermore, surface roughness cannot be completely removed even after polishing since the removal stock must be decreased, and occurrence of many failures, e.g., bonding failures is often observed in use of the wafer after regeneration.

Moreover, when the CZ wafer is used, a tendency of a reduction in a quality of an SOI layer of an SOI wafer fabricated by using a wafer obtained by regenerating a delaminated wafer as a bond wafer is observed, and defects are produced at a high level in some cases. Additionally, since the number of SOI wafers having a bonding failure is increased as the number of times of regeneration for the delaminated wafer is increased, there is also a problem of degradation in a yield ratio of each SOI wafer.

### DISCLOSURE OF THE INVENTION

In view of the above-explained problems, it is an object of the present invention to provide a method for reusing a delaminated wafer, which can increase the number of times of regeneration of the delaminated wafer and reduce a manufacturing cost for an SOI wafer without inducing bonding failures or a reduction in quality of an SOI layer even if the delaminated wafer is repeatedly reused as a bond wafer, the delaminated wafer being by produced when using a CZ wafer having a large diameter of 200 mm or above as a bond wafer to fabricate the SOI wafer based on an ion implantation delamination method.

To achieve this object, according to the present invention, there is provided a method for reusing a delaminated wafer, comprising a manufacturing process of forming a thermal oxide film on a surface of a CZ wafer, determining as a bond wafer the CZ wafer having an ion implanted layer formed by performing ion implantation through the thermal oxide film, bonding the bond wafer to a base wafer through the thermal oxide film, and applying a heat treatment to the bonded wafers to be separated into an SOI wafer and a delaminated wafer at the ion implanted layer, reprocessing of performing at least polishing to the byproduced delaminated wafer being added to the manufacturing process, thereby reusing the delaminated wafer as the bond wafer in the SOI wafer manufacturing process,
wherein, at least, the CZ wafer to be utilized is a low-defect wafer whose entire surface is formed of an N region, and
a rapid thermal annealing treatment is applied in the reprocessing to the delaminated wafer at a higher temperature than a temperature in the thermal oxide film formation performed to the bond wafer in the SOI wafer manufacturing process and a stock removal of the surface of the delaminated wafer is above 2µm in the regeneration polishing.

When the low-defect wafer that is the CZ wafer fully formed of an N region is used as the bond wafer utilized in the SOI wafer manufacturing process, it is possible to cope with an increase in diameter of the silicon wafer, e.g., 200 mm or above in recent years and manufacture the SOI wafer having the low-defect and high-quality SOI layer without using the CZ wafer having an extremely low oxygen concentration, e.g., 10 ppma or below.

Further, when the low-defect CZ wafer fully formed of the N region is used, a delaminating plane can be polished without concerning a stock removal. Therefore, a surface of the delaminated wafer can be greatly flattened as compared with a case using an epitaxial wafer, and a bonding failure of the SOI wafer due to the bond wafer regenerated from the delaminated wafer can be improved. Furthermore, since the number of times of regeneration from the delaminated wafer to the bond wafer is increased, a manufacturing cost of the SOI wafer can be substantially reduced.

Moreover, according to the reprocessing of the delaminated wafer, when a rapid thermal annealing treatment (an RTA treatment) is performed with respect to the delaminated wafer at a higher temperature than a temperature in thermal oxide film formation applied to the bond wafer in the SOI wafer manufacturing process, oxygen precipitation nuclei and oxide precipitates grown from these nuclei in the delaminated wafer formed by the heat treatment performed several times in the SOI wafer manufacturing process or the regeneration process can be dissolved and annihilated, the oxygen precipitation nuclei and the oxide precipitates in the delaminated wafer can be initialized to a state before they are formed, and hence the excessive oxide precipitates can be suppressed from being generated in the bond wafer regenerated from the delaminated wafer in the SOI wafer manufacturing process after the regeneration process.

Additionally, since the bond wafer regenerated from the delaminated wafer is initialized based on the RTA treatment, it has the same quality as that of an initially prepared bond wafer, a reduction in quality of the SOI layer formed by using this bond wafer can be prevented, and a bonding failure of the SOI wafer can be also improved.

Therefore, even if the delaminated wafer is subjected to the regeneration process more than once, since the bond wafer is initialized, the number of times of regeneration can be increased to a limit of a thickness of the CZ wafer while maintaining an excellent bonding quality of the SOI wafer, thereby reducing the SOI wafer manufacturing cost.

It is preferable to perform the rapid thermal annealing treatment before the step of performing regeneration polishing with respect to the surface of the delaminated wafer, and the rapid thermal annealing treatment can be carried out after the step of performing regeneration polishing with respect to the surface of the delaminated wafer.

Since the RTA treatment is carried out to annihilate oxygen precipitation nuclei and others formed in the delaminated wafer by the heat treatment performed several times in the SOI wafer manufacturing process or the regeneration process, the RTA treatment may be performed before or after the regeneration polishing step for the surface of the delaminated wafer. However, when the RTA treatment is preferably carried out with respect to the delaminated wafer before the regeneration polishing step, even if the surface of the delaminated wafer is contaminated due to the RTA treatment when performing regeneration polishing with respect to the surface of the delaminated wafer, the contamination can be removed, and changed surface roughness of the delaminated wafer can be adjusted. Therefore, a bonding failure of the SOI wafer caused due to the bond wafer subjected to regeneration polishing can be improved, thus avoiding a reduction in quality of the SOI wafer when the delaminate wafer is reused.

In this case, it is preferable to set a temperature in the rapid thermal annealing treatment to 1100°C to 1300°C.

When forming a thermal oxide film on the bond wafer, since the oxide film is formed at a temperature of approximately 1000°C, a temperature of 1100°C is preferable as an RTA treatment temperature, and setting the RTA treatment temperature to 1100°C or above enables annihilating oxygen precipitate nuclei and oxide precipitates generated in the bond wafer (the delaminated wafer) in the SOI manufacturing process. Therefore, in the SOI wafer manufacturing process after the regeneration process, oxide precipitates can be suppressed from being produced in the bond wafer regenerated from the delaminated wafer, a bonding failure of the SOI wafer caused due to the bond wafer subjected to regeneration polishing can be improved, and a reduction in quality of the SOI wafer when the delaminated wafer is reused can be avoided, thereby increasing the number of times of regeneration.

Further, in the regeneration polishing, a stock removal of the delaminated wafer surface can be set to 2 µm or above.

Even if the delaminating plane of the delaminated wafer is damaged due to ion implantation, since the low-defect CZ wafer fully formed of the N region is used as the bond wafer when manufacturing the SOI wafer in the present invention, a damaged layer of the delaminating plane can be subjected to regeneration polishing with a required thickness, and the delaminated wafer surface can be polished with a stock removal of 2 µm or above in particular. When the stock removal of the delaminated wafer surface is 2 µm or above, since the damaged layer of the delaminating plane can be assuredly removed and polishing sufficient for flattening can be provided, a bonding failure of the SOI wafer due to the bond wafer subjected to regeneration polishing can be improved, and a quality of the SOI wafer when reusing the delaminated wafer can be prevented from being reduced.

According to the method for reusing a delaminated wafer of the present invention, in manufacture of an SOI wafer based on the ion implantation delamination method, since it is possible to cope with a recent increase in diameter of a silicon wafer, e.g., 200 mm or above and oxygen precipitation nuclei and others in a delaminated wafer can be initialized by the RTA treatment even if the byproduced delaminated wafer having a large diameter is repeatedly reused as a bond wafer, a bonding failure or a reduction in quality of an SOI layer can be prevented, the number of times of regeneration of the bond wafer can be increased, and a manufacturing cost for the SOI wafer can be decreased.

### BRIEF DESCRIPTION OF THE DRAWINGS

FIG. 1 is a view showing an example of a flow of a method for reusing a delaminated wafer according to the present invention;
FIG. 2 is a view showing a flow of a process for manufacturing an SOI wafer based on an ion implantation delamination method;
FIG. 3 is a view showing a flow of a conventional method for reusing a delaminated wafer; and
FIG. 4 is a view showing flows of implemented processes according to the present invention which can be considered besides the flow depicted in FIG. 1, in which a flow (α) corresponds to a case where an RTA treatment at a step (F) is carried out during a step (G) and a flow (β) corresponds to a case where the RTA treatment at the step (F) is performed after end of the step (G).

### BEST MODE(S) FOR CARRYING OUT THE INVENTION

The present inventors examined a problem that a tendency of a reduction in quality of an SOI layer of an SOI wafer fabricated by using a wafer obtained by reprocessing a delaminated wafer as a bond wafer is observed, defects are generated at a high level, and the number of SOI wafers having a bonding failure is increased as the number of times of regeneration of the delaminated wafer is increased.

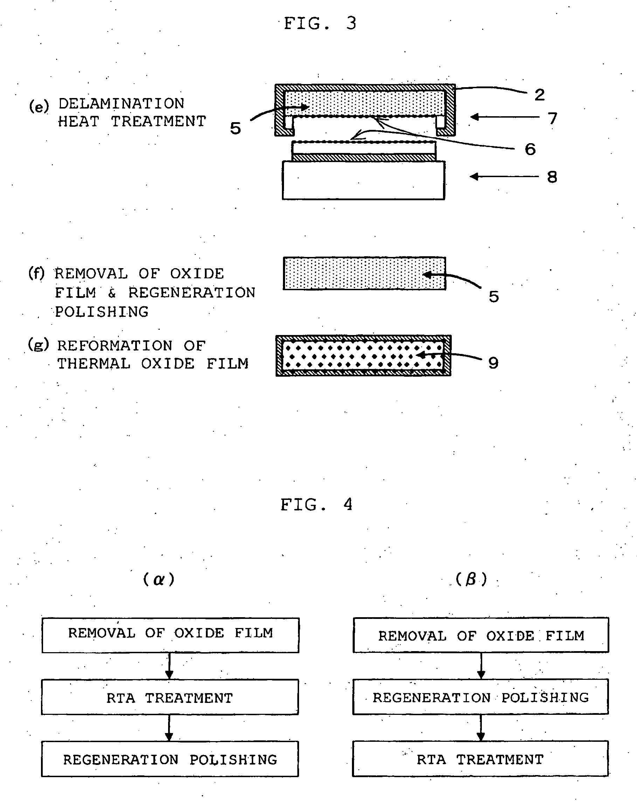

As a result, the present inventors found out that, when a CZ wafer is used as a wafer forming an SOI layer (a bond wafer) in two silicon single crystal wafers at the time of fabrication of an SOI wafer based on the ion implantation delamination method and a delaminated wafer is reused as the bond wafer, since a high-temperature oxidation heat treatment for formation of an oxide film and a low-temperature heat treatment for wafer separation (a delamination heat treatment) are applied to the bond wafer, generation and growth of oxygen precipitation nuclei are repeated in the bond wafer and oxide precipitates are increased. This mechanism will now be explained hereinafter with reference to FIG. 3.

FIG. 3 is a view showing a flow of a process for reprocessing a delaminated wafer based on a conventional method. When an SOI wafer 8 is fabricated as depicted in FIG. 2 (a step (e)), oxygen precipitation nuclei 5 are generated in a delaminated wafer 7, oxide film removal, regeneration polishing, and others are carried out at a step (f), and a thermal oxide film is again formed (a step (g)), which results in growth of the oxygen precipitation nuclei 5 generated in the SOI wafer manufacturing process into oxide precipitates 9.

When a process for removing a wafer surface is again carried out with respect to the wafer having the oxide precipitates 9 increased therein as a regeneration process like grinding/polishing, the oxide precipitates are present near the surface, which leads to a problem of a bonding failure or degradation in quality of an SOI layer. Furthermore, generation and growth of the oxygen precipitation nuclei 5 and/or the oxide precipitates 9 become prominent as the number of times of regeneration is increased, a quality of the SOI layer is degraded, thereby limiting the number of times of regeneration for the delaminated wafer to one or two. Moreover, since many bond wafers are required when the number of times of regeneration is small, a cost is increased.

To avoid such a problem and repeatedly use the delaminated wafer as the bond wafer, there can be considered suppressing formation of the oxide precipitates by a method for using an FZ wafer hardly containing interstitial oxygen or using an epitaxial wafer as the bond wafer or for fabricating and using a superlow-oxygen CZ wafer having an interstitial oxygen concentration of, e.g., 10 ppma or below based on an MCZ method.

However, forming a large diameter of 200 mm or above is difficult in the FZ wafer as explained above, and the number of times of regeneration for the delaminated wafer may be slightly increased when the CZ wafer having an interstitial oxygen concentration of 10 ppma or below is used, but a potential problem that defects due to oxygen are generated cannot be solved, and stably mass-producing the CZ wafer having an extremely low interstitial oxygen concentration of 10 ppma is also difficult under present circumstances. Moreover, there is also a problem that presence of a vacancy type defect (which may be referred to as a COP in some cases) inherent to the CZ wafer lowers a quality of the SOI layer.

Thus, the present inventors conceived that a recent increase in diameter of a wafer is realized and a delaminating plane is flattened without concerning a stock removal by using a low-defect CZ wafer fully formed of an N region as a bond wafer and oxygen precipitation nuclei and oxide precipitates in a delaminated wafer are annihilated to initialize the bond wafer by performing an RTA treatment to the delaminated wafer in a delaminated wafer regeneration process at a higher temperature than a temperature for formation of a thermal oxide film in an SOI wafer manufacturing process, thereby bringing the present invention to completion.

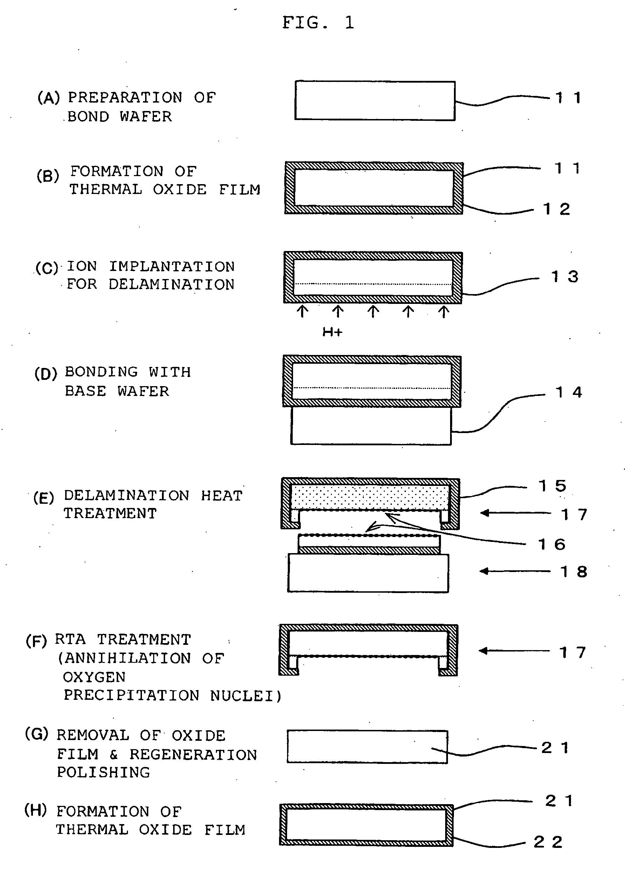

An embodiment according to the present invention will now be specifically explained hereinafter with reference to FIG. 1, but the present invention is not restricted thereto.

FIG. 1 is a view showing a flow of a method for reusing a delaminated wafer according to the present invention. As shown in FIG. 1, a CZ wafer 11 having a regular oxygen concentration (e.g., approximately 10 to 25 ppma) and at least one surface subjected to mirror polishing is prepared as a bond wafer (a step (A)), and a thermal oxide film 12 is formed on the surface thereof at a temperature of approximately 900 to 1200°C (a step (B)).

At this time, as the bond wafer to be prepared, a low-defect wafer whose entire surface is formed of an N region among CZ wafers is used. Since the low-defect wafer fully formed of the N region has less vacancy type defects and a high crystal quality as compared with a regular CZ wafer, it can be preferably utilized for an SOI layer, but it leads to an increase in cost since manufacturing conditions for pulling a single-crystal ingot are strict.

However, when this wafer is repeatedly used as the bond wafer like the present invention, a manufacturing cost for an SOI wafer having a high-quality SOI layer can be effectively reduced.

Additionally, when the low-defect CZ wafer fully formed of the N region is utilized as the bond wafer in the SOI manufacturing process, it is possible to cope with a recent increase in diameter of a silicon wafer, i.e., 200 mm or above without using an FZ wafer which hardly contains interstitial oxygen but is difficult to increase its diameter.

Further, then SOI wafer having the SOI layer with a higher quality than a regular CZ wafer can be manufactured without using a CZ wafer having an interstitial oxygen concentration of 10 ppma or below which is not stably mass-produced.

Further, since a delaminating plane can be polished without concerning a stock removal, a surface of the delaminated wafer can be highly flattened as compared with a case where an epitaxial wafer is used, and a bonding failure of the SOI wafer caused due to the bond wafer regenerated from the delaminated wafer can be improved. Furthermore, since the number of times of regeneration from the delaminated wafer to the bond wafer can be increased, a manufacturing cost for the SOI wafer can be substantially reduced.

Then, a hydrogen ion for delamination is implanted through the thermal oxide film 12 on the mirror-polished surface to form an ion implanted layer 13 (a step (C)). At a step (D), the bond wafer having the ion implanted layer 13 formed thereon is bonded to a base wafer 14 (a silicon single crystal wafer in this example) at a room temperature, then a low-temperature heat treatment (a delamination heat treatment) is carried out with respect to the bonded wafers at approximately 400 to 600°C to be delaminated into an SOI wafer 18 and a delaminated wafer 17 at a delaminating plane 16 of the ion implanted layer 13 (a step (E)). At this time, oxygen precipitation nuclei 15 (small oxide precipitates) are formed in a bulk portion of the delaminated wafer 17.

An RTA treatment is performed with respect to this delaminated wafer 17 in, e.g., an argon atmosphere (a step (F)).

As a result, the oxide precipitates in the delaminated wafer formed by the heat treatment performed several times in the SOI wafer manufacturing process or the second regeneration process can be annihilated. Furthermore, the oxygen precipitation nuclei and the oxide precipitates in the delaminated wafer can be initialized, and hence the oxide precipitates in the bond wafer regenerated from the delaminated wafer can be suppressed in the SOI wafer manufacturing process after the regeneration process.

Moreover, since the inside of the bond wafer regenerated from the delaminated wafer subjected to the RTA treatment is initialized like the initially prepared bond wafer, a quality of an SOI layer of the SOI wafer to be fabricated can be prevented from being reduced even if the bond wafer is used to perform the SOI wafer manufacturing process, and a bonding failure can be improved.

Therefore, since the bond wafer is initialized every time even if the regeneration process is carried out with respect to the delaminated wafer more than once, the number of times of regeneration can be increased to a limit of a thickness of the CZ wafer while maintaining an excellent bonding quality of the SOI wafer, thereby reducing the SOI wafer manufacturing cost.

In this case, it is preferable to set a temperature in the RTA treatment to a temperature higher than an oxidation temperature at the step (B), especially 1100°C to 1300°C. When this temperature is set to a temperature higher than the thermal oxide film forming temperature, especially 1100°C or above, the oxygen precipitation nuclei 15 formed in the heat treatment at the step (B) or the step (E) or its temperature reducing process can be annihilated, thus initializing the inside of the delaminated wafer 17.

Additionally, since a melting point of silicon is approximately 1400°C, when the temperature in the RTA treatment is set to 1300°C or above, there may occur a problem that a slip dislocation is produced in the delaminated wafer, a shape is changed, or flatness of the bond wafer is lost to degrade a crystal quality in the RTA treatment, and hence a temperature of 1300°C or below is preferable as the RTA heat treatment temperature.

Then, a surface of the delaminated wafer 17 having the oxygen precipitation nuclei 15 annihilated therein is subjected to regeneration polishing. For example, the regeneration polishing can be carried out by removing the oxide film on the surface by using an HF aqueous solution and then polishing the delaminating plane 16 (a step (G)).

At this time, since the oxygen precipitation nuclei or the oxide precipitates are hardly formed in the delaminated wafer, even if a stock removal of 2 µm or above is required to remove a step formed at a peripheral portion of the delaminating plane, the oxide precipitates are not exposed on the surface after polishing, and a problem that the bonding failure is induced does not occur. Therefore, surface grinding or chemical etching can be applied as the regeneration process before the polishing process.

Further, even if the delaminated wafer is damaged due to ion implantation, since the low-defect CZ wafer fully formed of the N region is used, regeneration polishing can be carried out with a necessary thickness, thus enabling polishing with a stock removal of approximately 2 µm or above. Based on such regeneration polishing, since the damaged layer of the delaminated wafer can be removed and the surface of the delaminated wafer can be sufficiently flattened, the bonding failure of the SOI wafer caused due to the bond wafer subjected to regeneration polishing can be improved, and a reduction in quality of the SOI wafer when reusing the delaminated wafer can be avoided. It is to be noted that performing regeneration polishing with a small stock removal so that the damaged layer of the delaminated wafer can be removed enables increasing the number of times of regeneration for the delaminated wafer.

When a thermal oxide film 22 is again formed on a bond wafer 21 obtained by regenerating the delaminated wafer 17 in this manner, the same bond wafer as that at the step (B) can be acquired (a step (H)).

It is to be noted that there are such flows as depicted in FIGS. 4(α) and (β) as flows of the present invention that can be considered besides the above-explained flow of the present invention shown in FIG. 1. The RTA treatment at the step (F) in FIG. 1 can be carried out after regeneration polishing like the flow (β) and can be also performed before regeneration polishing after removal of the oxide film like the flow (α).

Since the RTA treatment is performed in order to annihilate the oxygen precipitation nuclei and others formed in the delaminated wafer due to the heat treatment performed more than once in the SOI wafer manufacturing process or the regeneration process, the RTA treatment may be carried out after the regeneration polishing process for the delaminated wafer surface as shown in the flow (β) in FIG. 4. However, preferably, when the surface of the delaminated wafer is subjected to regeneration polishing by performing the RTA treatment with respect to the delaminated wafer before the regeneration polishing process as shown in FIG. 1, even if the RTA treatment causes contamination or a change in surface roughness, it can be removed or adjusted.

Although examples of the present invention will be further specifically explained hereinafter, the present invention is not restricted thereto.

### (Examples)

### <Manufacture of SOI Wafer 1>

(A) 40 CZ wafers (an oxygen concentration: 16 ppma) each of which is fully formed of an N region and has a diameter of 300 mm were prepared, and (B) a thermal oxide film with a thickness of 400 nm was formed on a surface of each wafer based on pyrogenic oxidation at 1000°C in order to use 10 of these CZ wafers as bond wafers.
(C) A hydrogen ion is implanted through this oxidation film. At this time, energy of 70 KeV and an implantation amount of 6×10¹⁶/cm² were adopted as hydrogen ion implantation conditions and an ion implanted layer was formed in each bond wafer.
(D) This bond wafer was bonded to each of remaining 10 silicon single crystal wafers at a room temperature, and then (E) a delamination heat treatment was applied at 500°C for 30 minutes to perform delamination at each ion implanted layer.

Observing voids or blister failures in the 10 SOI wafers after delamination, it was found that these failures are not generated in all of the 10 wafers.

### <Reprocessing of Delaminated Wafer 1>

(F) Then, the RTA treatment was carried out with respect to each delaminated wafer in an atmosphere containing 100% of argon at 1150°C for 60 seconds by a lamp heating type RTA device, then (G) the oxide film formed on the surface was removed, and a delaminating plane was polished for 4 µm to fabricate a new bond wafer (a second time).

### <Manufacture of SOI wafer 2>

This bond wafer (the second time) was used to fabricate 10 SOI wafers and 10 delaminated wafers (the second time) based on the same processing as the previous processing.

### <Reprocessing of Delaminated Wafer 2>

Further, the RTA treatment was carried out with respect to each delaminated wafer (the second time) in an atmosphere containing 100% of argon at 1200°C for 60 seconds by the lamp heating type RTA device, then the oxide film formed on the surface was removed, and a delaminating plane was polished for 4 µm to fabricate a new bond wafer (a third time).

### <Manufacture of SOI Wafer 3>

This bond wafer (the third time) was used to fabricate 10 SOI wafers and 10 delaminated wafers (the third time) based on the same processing as the previous processing.

Furthermore, observing voids or blister failures in the respective 10 SOI wafers fabricated by the second or third delamination heat treatment, it was revealed that these failures were not generated like the first time..

### (Comparative Example)

The same process as that in Example was used to manufacture SOI wafers except that the RTA treatment in an argon atmosphere for annihilation of oxygen precipitation nuclei or oxide precipitates generated in each delaminated wafer is not performed with respect to the delaminated wafer.

Moreover, observing voids or blister failures in respective 10 SOI wafers fabricated by each of first to third delamination heat treatments, voids or blister failures were not observed in the 10 SOI wafers manufactured by the first delamination heat treatment, but these failures were observed in two SOI wafers manufactured by the second delamination heat treatment and in five SOI wafers manufactured by the third delamination heat treatment.

It can be understood from Example and Comparative Example that, when the low-defect CZ wafer fully formed of the N region is used as the bond wafer for manufacture of the SOI wafer like the present invention and the RTA treatment is carried out to the delaminated wafer in the reprocessing to initialize the delaminated wafer, occurrence of failures such as voids or blisters is suppressed in the SOI wafer manufactured according to the present invention.

Therefore, according to the method for reprocessing the delaminated wafer of the present invention, the number of times of regeneration of the delaminated wafer can be increased as compared with a conventional example, and an SOI wafer manufacturing cost can be substantially reduced, and a quality of the SOI wafer to be obtained can be improved.

It is to be noted that this specification uses a criterion of JEIDA (an abbreviation of Japan Electronic Industry Development Association. It is now renamed to JEITA (Japan Electronics and Information Technology Industries Association)) for a unit of an interstitial oxygen concentration.

Further, the present invention is not restricted to the foregoing embodiment. The foregoing embodiment is just an exemplification, and any examples, which have substantially the same configuration and demonstrate the same functions and effects as the technical concept described in claims of the present invention are included in the technical scope of the present invention.

## Claims

1. A method for reusing a delaminated wafer, comprising a manufacturing process of forming a thermal oxide film on a surface of a CZ wafer, determining as a bond wafer the CZ wafer having an ion implanted layer formed by performing ion implantation through the thermal oxide film, bonding the bond wafer to a base wafer through the thermal oxide film, and applying a heat treatment to the bonded wafers to be separated into an SOI wafer and a delaminated wafer at the ion implanted layer, reprocessing of performing at least polishing to the byproduced delaminated wafer being added to the manufacturing process, thereby reusing the delaminated wafer as the bond wafer in the SOI wafer manufacturing process,
wherein, at least; the CZ wafer to be utilized is a low-defect wafer whose entire surface is formed of an N region,
a rapid thermal annealing treatment is applied in the reprocessing to the delaminated wafer at a higher temperature than a temperature in the thermal oxide film formation performed to the bond wafer in the SOI wafer manufacturing process, and
a stock removal of the surface of the delaminate wafer is above 2 µm in the regeneration polishing.

2. The method for reusing a delaminated wafer according to claim 1, wherein the rapid thermal annealing treatment is performed before a step of carrying out regeneration polishing with respect to a surface of the delaminated wafer.

3. The method for reusing a delaminated wafer according to claim 1, wherein the rapid thermal annealing treatment is performed after a step of carrying out regeneration polishing with respect to a surface of the delaminated wafer.

4. The method for reusing a delaminated wafer according to any one of claims 1 to 3, wherein a temperature in the rapid thermal annealing treatment is set to 1100°C to 1300°C.

## Patentansprüche

1. Verfahren zur Wiederverwendung eines delaminierten Wafers, umfassend einen Herstellungsvorgang zum Bilden eines thermischen Oxidfilms auf einer Oberfläche eines CZ-Wafers, Bestimmen als einen Bond-Wafer den CZ-Wafer mit einer ionenimplantierten Schicht, gebildet durch Durchführen von Ionenimplantation durch den thermischen Oxidfilm, Bonden des Bond-Wafers an einen Base-Wafer durch den thermischen Oxidfilm, und Anwenden einer Wärmebehandlung an die gebondeten Wafer, welche in einen SOI-Wafer und einen delaminierten Wafer an der ionenimplantierten Schicht zu trennen sind, Wiederaufbereiten des Durchführens von zumindest Polieren an den neben-produzierten delaminierten Wafer, welcher zu dem Herstellungsvorgang hinzugefügt wird, dadurch Wiederverwenden des delaminierten Wafers als den Bond-Wafer in dem SOI-Wafer Herstellungsvorgang,
wobei zumindest; der zu verwendende CZ-Wafer ein Wafer mit niedriger Fehlerquote ist, dessen gesamte Oberfläche aus einer N-Region gebildet ist,
eine schnelle thermische Annealing-Behandlung in dem Wiederaufbereiten an den delaminierten Wafer bei einer höheren Temperatur als einer Temperatur in der thermischen Oxidfilmbildung, durchgeführt an dem Bond-Wafer in dem SOI-Wafer Herstellungsvorgang, angewendet wird, und
eine Abtragsleistung auf der Oberfläche des delaminierten Wafers oberhalb 2 µm in dem Regenerierungspolieren ist.

2. Verfahren zum Wiederverwenden eines delaminierten Wafers nach Anspruch 1, wobei die schnelle thermische Annealing-Behandlung vor einem Schritt des Durchführens von Regenerierungspolieren, bezogen auf eine Oberfläche des delaminierten Wafers, durchgeführt wird.

3. Verfahren zum Wiederverwenden eines delaminierten Wafers nach Anspruch 1, wobei die schnelle thermische Annealing-Behandlung nach einem Schritt des Durchführens von Regenerierungspolieren, bezogen auf eine Oberfläche des delaminierten Wafers, durchgeführt wird.

4. Verfahren zum Wiederverwenden eines delaminierten Wafers nach einem beliebigen der Ansprüche 1 bis 3, wobei eine Temperatur in der schnellen thermischen Annealing-Behandlung auf 1100°C bis 1300°C eingestellt wird.

## Revendications

1. Procédé de réutilisation d'une tranche décollée, comprenant un processus de fabrication pour former un film d'oxyde thermique sur une surface d'une tranche CZ, déterminer comme une tranche de liaison la tranche CZ ayant une couche à implantation ionique formée en exécutant une implantation ionique à travers le film d'oxyde thermique, lier la tranche de liaison à une tranche de base à travers le film d'oxyde thermique, et appliquer un traitement thermique aux tranches liées pour qu'elles soient séparées en une tranche de SOI et une tranche décollée au niveau de la couche à implantation ionique, un retraitement pour exécuter au moins un polissage de la tranche décollée comme sous-produit étant ajouté au processus de fabrication, réutilisant ainsi la tranche décollée comme la tranche de liaison dans le processus de fabrication de tranche de SOI,
dans lequel, au moins, la tranche CZ devant être utilisée est une tranche présentant peu de défauts dont la totalité de la surface est constituée d'une région N,
un traitement de recuit thermique rapide est appliqué dans le retraitement de la tranche décollée à une température supérieure à une température dans la formation de film d'oxyde thermique exécutée sur la tranche de liaison dans le processus de fabrication de tranche de SOI, et
une élimination de matière de la surface de la tranche décollée est supérieure à 2 µm dans le polissage de régénération.

2. Procédé de réutilisation d'une tranche décollée selon la revendication 1, dans lequel le traitement de recuit thermique rapide est exécuté avant une étape d'exécution d'un polissage de régénération par rapport à une surface de la tranche décollée.

3. Procédé de réutilisation d'une tranche décollée selon la revendication 1, dans lequel le traitement de recuit thermique rapide est exécuté après une étape d'exécution d'un polissage de régénération par rapport à une surface de la tranche décollée.

4. Procédé de réutilisation d'une tranche décollée selon l'une quelconque des revendications 1 à 3, dans lequel une température dans le traitement de recuit thermique rapide est fixée à 1 100 °C à 1 300 °C.
